## Europäisches Patentamt
## European Patent Office
## Office européen des brevets

(19)

(11) Veröffentlichungsnummer : **0 141 129**
**B1**

(12)

# EUROPÄISCHE PATENTSCHRIFT

(45) Veröffentlichungstag der Patentschrift :
26.04.89

(51) Int. Cl.⁴ : **H 03 G   3/32**

(21) Anmeldenummer : **84110248.6**

(22) Anmeldetag : **29.08.84**

(54) Verfahren zum Anpassen der Lautstärke eines Lautsprechers an einen am Lautsprecherort herrschenden Störgeräuschpegel.

(30) Priorität : **22.09.83 DE 3334262**

(43) Veröffentlichungstag der Anmeldung :
**15.05.85 Patentblatt 85/20**

(45) Bekanntmachung des Hinweises auf die Patenterteilung : **26.04.89 Patentblatt 89/17**

(84) Benannte Vertragsstaaten :
**AT CH DE FR GB IT LI**

(56) Entgegenhaltungen :
**RADIO FERNSEHEN ELEKTRONIK, Band 29, Nr. 8, August 1980, Seite 539, Berlin, DE; "Störgeräuschabhängige automatische Lautstärkesteuerung"**
**ELECTRICAL DESIGN NEWS, Band 26, Nr. 1, 7. Januar 1981, Seite 202, Boston, Massachusetts, US; J. GRAEME: "Feedback lowers AGC distortion"**
**TECHNISCHE MITTEILUNGEN AEG-TELEFUNKEN, Band 61, Nr. 3, 1971, Seiten 186-189; A. HÄFNER: "Geräuschabhängige elektronische Lautstärkeeinstellung EL 100"**

(73) Patentinhaber : **Blaupunkt-Werke GmbH**
**Robert-Bosch-Strasse 200**
**D-3200 Hildesheim (DE)**

(72) Erfinder : **Germer, Horst, Prof. Dr. -Ing.**
**Edo-Wiemken-Strasse 30 ·**
**D-2948 Schortens 3 (DE)**

(74) Vertreter : **Eilers, Norbert, Dipl.-Phys.**
**Blaupunkt-Werke GmbH Robert-Bosch-Strasse 200**
**D-3200 Hildesheim (DE)**

**Beschreibung**

Die Erfindung betrifft ein Verfahren zum Anpassen der Lautstärke eines Lautsprechers, insbesondere in einem mobilen Rundfunkempfänger, wie Autoradio oder dergleichen, an einen am Lautsprecherort herrschenden Störgeräuschpegel der im Oberbegriff des Anspruchs 1 angegebenen Art.

Mit einem solchen Verfahren wird die Lautstärke entsprechend dem Geräuschpegel in der Umgebung des Lautsprechers so eingestellt, daß der Wiedergabepegel des Lautsprechers, also der Nutzsignalpegel, immer einige Dezibel (dB) größer ist als der Störgeräuschpegel. Dadurch wird das vom Lautsprecher abgestrahlte Nutzsignal von dem Hörenden, unabhängig von dem jeweiligen Stärkegrad der Umweltgeräusche, in etwa immer gleich laut empfunden.

Aus der Druckschrift « Technische Mitteilungen AEG-Telefunken », Band 61, Nr. 3, 1971, Seiten 186-189 ist eine geräuschabhängige elektronische Lautstärkeeinstellung bekannt, bei der mittels eines über ein Mikrofon aufgenommenen akustischen Störgeräuschpegels die Lautstärke einer Beschallungsanlage an das am Wiedergabeort herrschende Störgeräusch angepaßt wird. Eine Anpassung der Lautstärke erfolgt über Schwellwertstufen, die von dem Ausgangssignal des Mikrofons angesteuert werden. Für die Dauer einer Durchsage, also bei vorhandenem Nutzsignal, ist eine Auswertung des Störsignals nicht möglich, da dann zwischen Störgeräusch und Durchsage nicht unterschieden werden kann.

Aus der Druckschrift « RADIO FERNSEHEN ELEKTRONIK », Band 29, Nr. 8, August 1980, Seite 539 ist eine störgeräuschabhängige automatische Lautstärkesteuerung bekannt, bei der als Aufnehmer für den sich ändernden Geräuschpegel im Autoradio ein gegen Körperschall geschütztes Kondensatormikrofon vorgesehen ist. Das NF-Signal am Lautsprecheranschluß wird zur Realisierung der störgeräuschabhängigen automatischen Lautstärkesteuerung gleichgerichtet, gesiebt und einer Pegelvergleichsstufe zugeführt. An diese Stufe gelangt nach entsprechender Verstärkung und Gleichrichtung auch das vom Mikrofon aufgenommene Signal. Aus dem Vergleich wird ein Steuersignal gewonnen, das über eine entsprechende Anpassung die Verstärkung des NF-Verstärkers automatisch verändert. Auf diese Weise vergrößert oder verkleinert sich die Lautstärke in Abhängigkeit vom vorhandenen Geräuschpegel.

Bei bekannten Verfahren dieser Art wird als Stellgröße die im Mikrofonausgangssignal enthaltene, vom Störgeräusch herrührende Störkomponente verwendet. Hierzu wird eine Gegenspannung erzeugt, die gleich der im Mikrofonausgangssignal enthaltenen, vom Lautsprechersignal herrührenden Nutzkomponente ist, und die Gegenspannung von der Mikrofonausgangsspannung subtrahiert. Als Differenzspannung ergibt sich bei richtiger Bemessung der Gegenspannung die Störkomponente, die als Stellgröße auf den Regelverstärker gegeben wird.

Bei einer Schaltungsanordnung zur Durchführung dieses Verfahrens wird hierzu die Lautsprechereingangs- oder Nutzspannung auf einen Spannungsverstärker gegeben, dessen Verstärkungsfaktor entsprechend bemessen wird, da die Größe der Nutzkomponente von verschiedenen Faktoren, wie z. B. der gegenseitigen Zuordnung von Mikrofon und Lautsprecher, von der Art des Lautsprecherorts, von der Anordnung mehrerer Lautsprecher und dergleichen, abhängig ist. Zur Einstellung des Verstärkungsfaktors ist ein Abstimmglied vorgesehen, mit welchem die Spannungsverstärkung nach Anordnung des Mikrofons am Lautsprecherort solange verändert wird, bis der Einfluß des Lautsprechersignals auf die Lautstärkeeinstellung nicht mehr wahrgenommen wird.

Eine solche vor Ort durchzuführende Abstimmung der Schaltungsanordnung ist aufwendig und erfordert eigens dafür geschultes Fachpersonal, so daß der Einbau von z. B. mit einer solchen Schaltungsanordnung ausgerüsteten Autoradios nicht in jeder Werkstatt zufriedenstellend durchgeführt werden kann. Zum anderen muß für eine optimale Funktion der Schaltungsanordnung die Abstimmung an sich ändernde Bedingungen des Aufstellungsorts, z. B. des Kraftfahrzeuginnenraums, angepaßt werden. So ist bei vollbesetztem Kraftfahrzeug gegenüber einem leeren Kraftfahrzeuginnenraum unter Umständen eine Veränderung im Abgleich der Schaltungsanordnung erforderlich, damit diese optimal arbeitet.

Der Erfindung liegt die Aufgabe zugrunde, ein Verfahren der eingangs genannten Art anzugeben, das unabhängig von Einflüssen des Lautsprecherorts ist und damit einerseits ein Abstimmen auf räumliche Gegebenheiten des Lautsprecherorts überflüssig macht und andererseits auch bei sich ändernden räumlichen Gegebenheiten des Lautsprecherorts störungsfrei funktioniert.

Die Aufgabe ist bei einem Verfahren zum Anpassen der Lautstärke eines Lautsprechers an einen am Lautsprecherort herrschenden Störgeräuschpegel der im Oberbegriff des Anspruchs 1 definierten Art erfindungsgemäß durch die Merkmale im Kennzeichnungsteil des Anspruchs 1 gelöst.

Bei dem erfindungsgemäßen Verfahren ist die im Mikrofonausgangssignal enthaltene elektrische Störgeräuschkomponente ebenfalls ein Maß für die Stellgröße des Regelverstärkers, da die Hüllkurven von Mikrofonausgangssignal und dem Lautsprecher zugeführtem Nutzsignal einander um so ähnlicher sind, je geringer der im akustischen Signal enthaltene Störgeräuschanteil ist. Durch die erfindungsgemäße Ableitung der Stellgröße für den Regelverstärker aus dem Ähnlichkeitssignal der Hüllkurven wird der Einfluß der von räumlichen Gegebenheiten des Lautsprecherorts, wie z. B. Art und Besetzung des Fahrzeuginnenraums, Lautsprecher-Mikrofon-Abstand, Lautsprecherart, Fader- und Balanceeinstellung, abhängigen Kopplungsfaktoren zwischen Lautsprecher und Mikrofon einerseits und Störgeräusche und Mikrofon andererseits eliminiert. Laufzeitverzögerungen des aus Lautsprecherausgangssignal und Störgeräusch sich zusammensetzenden akustischen Signals gegenüber dem Nutzsignal spielen praktisch keine Rolle, so daß keine Verzögerungseinrichtung für das früher eintreffende Signal erforderlich ist. Ebenso wirken sich die Laufzeitunterschiede bei Verwendung mehrerer Lautsprecher praktisch nicht aus.

Darüber hinaus gibt der Ähnlichkeitsvergleich der Hüllkurven die Möglichkeit, das Verfahren digital mit Computereinsatz zu realisieren, was einerseits durch die für die Abtastung der Hüllkurven völlig ausreichende niedrige Abtastfrequenz und andererseits durch geringe Integrationszeiten für die Stellgrößengewinnung aufgrund der bereits größeren Ähnlichkeit der Hüllkurven — im Vergleich zu den Signalen selbst — bedingt ist.

Je größer der Störanteil im akustischen Signal ist, desto häufiger treten Steigungen mit verschiedenen Vorzeichen auf und desto kleiner wird das Ähnlichkeitssignal.

Eine vorteilhafte Ausgestaltung des erfindungsgemäßen Verfahrens ergibt sich aus Anspruch 2. Dadurch wird eine Integralwirkung erzielt, die das Differenzsignal zu Null macht.

Eine vorteilhafte Ausgestaltung des erfindungsgemäßen Verfahrens ergibt sich auch aus Anspruch 3. Diese Maßnahmen erlauben ein besonders feinfühliges Anpassen des Regelverhaltens an das subjektive Lautstärkeempfinden des menschlichen Ohrs, insbesondere bei der digitalen Realisierung des Verfahrens. Der Regelbereich wird nach oben und unten begrenzt, wodurch ein Über- oder Untersteuern in Extremsituationen sicher vermieden wird.

Eine vorteilhafte Ausgestaltung des erfindungsgemäßen Verfahrens ergibt sich auch aus Anspruch 4. Durch diese Maßnahmen werden auch akustische Rauschsignale ohne eigene Dynamik in die Störgeräuscherkennung und Lautstärkeanpassung einbezogen.

Vorteilhaft ist dabei die weitere Ausgestaltung des erfindungsgemäßen Verfahrens nach Anspruch 5. Hierdurch werden die Verhältnisse bei der Anpassung an Rauschpegel ohne eigene Dynamik derart optimiert, daß für den Hörer befriedigende Ergebnisse erzielt werden.

Eine vorteilhafte Ausführungsform der Erfindung ergibt sich auch aus Anspruch 6. Durch diese Maßnahmen wird eine unerwünschte Erhöhung der Lautstärke nach Beendigung von Signalpausen im Nutzspannungssignal unterbunden, die dadurch bedingt ist, daß das Ähnlichkeitssignal in Signalpausen bei anwesendem Störgeräusch sehr klein wird und damit zu einer großen Stellgröße führt.

Eine vorteilhafte Schaltungsanordnung zur Realisierung des erfindungsgemäßen Verfahrens ist in Anspruch 7 angegeben. Eine vorteilhafte, wenig aufwendige Ausführungsform eines Stellgrößengenerators ergibt sich aus dem Anspruch 8.

Die Erfindung ist anhand von in der Zeichnung dargestellten Ausführungsbeispielen einer Schaltungsanordnung zum selbsttätigen Anpassen der Lautstärke eines Lautsprechers an einen im Kraftfahrzeuginnenraum herrschenden Störgeräuschpegel im folgenden näher beschrieben. Es zeigen :

Fig. 1 ein Blockschaltbild der Schaltungsanordnung,
Fig. 2 ein Blockschaltbild einer Ähnlichkeits-Vergleichsschaltung der Schaltungsanordnung in Fig. 1,
Fig. 3 und 4 jeweils ein Blockschaltbild eines Stellgrößengenerators der Schaltungsanordnung in Fig. 1 gemäß einem ersten und zweiten Ausführungsbeispiel,
Fig. 5 und 6 jeweils ein Blockschaltbild einer Wichtungsvorrichtung der Schaltungsanordnung in Fig. 1 gemäß einem ersten und zweiten Ausführungsbeispiel.

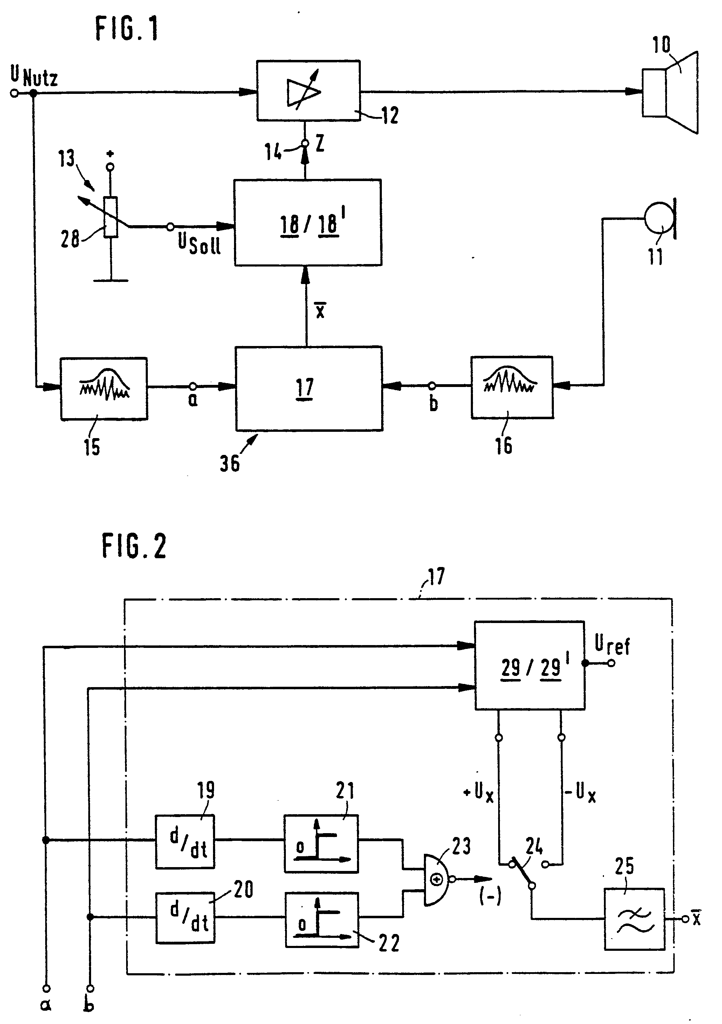

Bei dem mittels der Schaltungsanordnung in Fig. 1 realisierbaren Verfahren zum Anpassen der Lautstärke eines Lautsprechers (10) eines Autoradios an einen am Lautsprecherort, d. h. im Kraftfahrzeuginnenraum, herrschenden Störgeräuschpegel wird ein Mikrofon (11) verwendet, das das vom Lautsprecher abgestrahlte akustische Lautsprecherausgangssignal, mitunter auch Nutzsignal genannt, und das im Kraftfahrzeuginnenraum herrschende Störgeräusch gleichzeitig erfaßt. Aus dem elektrischen Mikrofonausgangssignal wird eine Stellgröße (z) für einen üblicherweise im Autoradio enthaltenen Regelverstärker (12) generiert und entsprechend das dem Lautsprecher zugeführte elektrische Nutzsignal $U_{Nutz}$ in Abhängigkeit von dem Störgeräusch verstärkt.

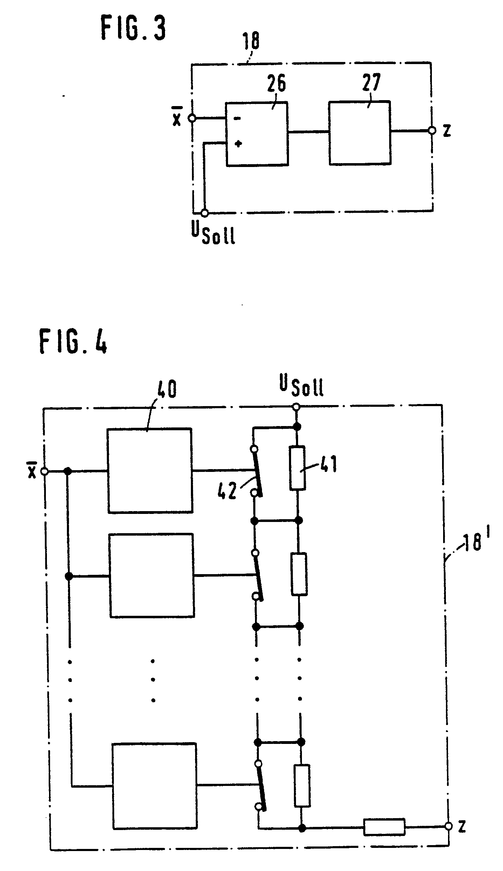

Zur Gewinnung der Stellgröße (z) für den Regelverstärker (12) werden die Hüllkurven von elektrischem Nutzsignal $U_{Nutz}$ und elektrischem Mikrofonausgangssignal fortlaufend auf Ähnlichkeit geprüft und ein dem Ähnlichkeitsgrad proportionales Ähnlichkeitssignal ($\overline{x}$) erzeugt. Das Ähnlichkeitssignal ist um so größer, je ähnlicher sich die beiden Hüllkurven sind. Die Hüllkurven sind sich wiederum desto ähnlicher, je geringer der Störgeräuschpegel ist. Das Ähnlichkeitssignal ($\overline{x}$) wird nach einer ersten Methode, wie sie schaltungsmäßig in Fig. 3 dargestellt ist, mit einem vorgegebenen Sollwert $U_{Soll}$ verglichen, der vorzugsweise in Abhängigkeit von der vorgewählten Lautstärke vorgegeben wird. Die Lautstärke wird wiederum mittels eines als Sollwertgeber (28) ausgebildeten manuellen Lautstärkestellers (13) von dem Bedienenden auf den gewünschten Wert eingestellt. Die Differenz zwischen Ähnlichkeitssignal und Sollwert wird integriert und bildet die dem Regelverstärker (12) über seinen Steuereingang (14) zugeführte Stellgröße (z). Entsprechend dieser Stellgröße (2) wird die manuell voreingestellte Lautstärke verändert. Nach einer zweiten Methode, wie sie mit der in Fig. 4 dargestellten Schaltung durchgeführt werden kann, wird der Variationsbereich des Ähnlichkeitssignals ($\overline{x}$) durch Schwellwertstufen unterteilt und bei Durchlaufen der Schwellwertstufen durch das Ähnlichkeitssignal ($\overline{x}$) die jeweilige Lautstärke, deren Anfangswert durch die Sollspannung $U_{Soll}$ vorgegeben ist, um je einen Schnitt erhöht oder reduziert, je nach Durchlaufrichtung des Ähnlichkeitssignals ($\overline{x}$) durch die Schwellwertstufen. Den Schwellwertstufen kann jeweils eine obere und eine untere Schaltschwelle zugeordnet sein, wobei die Regelung so erfolgt, daß die Stellgröße (z) jeweils beim Unterschreiten der unteren Schaltschwelle erhöht und beim Überschreiten der oberen Schaltschwelle reduziert wird. Die Sollspannung $U_{Soll}$ wird wiederum von dem als Sollwertgeber (28) ausgebildeten Lautstärkesteller (13) vorgegeben.

Das vorstehend beschriebene Verfahren läßt sich sowohl digital und unter Verwendung eines Mikroprozessors als auch analog realisieren. In den Ausführungsbeispielen gemäß Fig. 1-6 ist zur Durchführung des Verfahrens eine analoge Schaltungsanordnung gewählt.

Bei dieser Schaltungsanordnung ist — ebenso wie bei einer digitalen Variante — das an dem Eingang des Regelverstärkers (12) gelegte elektrische Nutzsignal $U_{Nutz}$ einem ersten Hüllkurvendetektor (15) und das elektrische Mikrofonausgangssignal einem zweiten Hüllkurvendetektor (16) einer Regelvorrichtung (36) zugeführt. Die beiden Hüllkurvendetektoren (15, 16) sind mit einer Vergleichsschaltung (17) verbunden, die die beiden Hüllkurven von Nutzsignal und Mikrofonausgangssignal auf Ähnlichkeit vergleicht und an ihrem Ausgang ein Ähnlichkeitssignal erzeugt. Der Vergleichsschaltung (17) ist ein Stellgrößengenerator (18 bzw. 18') nachgeschaltet, dessen Ausgang mit dem Steuereingang (14) des Regelverstärkers (12) verbunden ist.

Eine Ausführungsform der Vergleichsschaltung (17) is in Fig. 2 im Blockschaltbild dargestellt. Jedem Hüllkurvendetektor (15, 16) ist über die Eingänge a und b der Vergleichsschaltung (17) die Reihenschaltung aus einem Differenzierer (19 bzw. 20) und einem Nullspannungskomparator (21 bzw 22) nachgeschaltet. Die Ausgänge der beiden Nullspannungskomparatoren (21, 22) sind mit einem Koinzidenzglied (23), hier einem Äquivalenz-Gatter, verbunden, an dessen Ausgang der Steuereingang eines Umschalters (24) angeschlossen ist. Je nach Ausgangssignal des Koinzidenzgliedes (23) legt der Umschalter (24) einen als Tiefpaß (25) ausgebildeten Mittelwertbildner an einen positiven bzw. negativen Spannungswert $U_x$, so daß am Ausgang des Umschalters jeweils ein oberer und ein unterer Ausgabewert abnehmbar ist.

Die Differenzierer (19, 20) erfassen die Änderungen in den Hüllkurvensignalen. Ist die Änderung, also die Steigung der Hüllkurve, positiv, so steht am Ausgang des zugeordneten Nullspannungskomparators (21 bzw. 22) ein logisch « I »-Signal an, ist die Steigung negativ, ein logisch « O »-Signal. Bei Koinzidenz der Vorzeichen der Steigungen der beiden Hüllkurven erscheint am Ausgang des Koinzidenzgliedes (23) ein logisch « I »-Signal und der Umschalter (24) nimmt die in Fig. 2 dargestellte Stellung ein. Im anderen Fall, also bei verschiedenen Vorzeichen der Steigungen, tritt am Ausgang des Koinzidenzgliedes (23) ein logisch « O »-Signal auf und der Umschalter (24) verbindet den Tiefpaß (25) mit dem Spannungswert $-U_x$. Am Ausgang des Tiefpasses (25) ist der zeitliche Mittelwert der entsprechend den Vorzeichen der Steigungen der Hüllkurve angelegten Spannungsbeträge $+ U_x$ und $-U_x$ als Ähnlichkeitssignal $(\bar{x})$ abnehmbar. Dieses Ähnlichkeitssignal nähert sich dem Wert $+ U_x$, wenn die Hüllkurven gleich sind, und geht gegen Null, wenn die Hüllkurven sich extrem unähnlich sind.

Bei einer digitalen Schaltungsanordnung wäre es zweckmäßig, die an den Eingängen (a und b) der Vergleichsschaltung auftretenden Hüllkurvensignale digital abzutasten und die einzelnen Abtastwerte digital miteinander zu vergleichen.

Das Ähnlichkeitssignal $(\bar{x})$ wird dem Stellgrößengenerator (18 bzw. 18') zugeführt, der aus dem Ähnlichkeitssignal $(\bar{x})$ eine Stellgröße (z) generiert und hierzu mit dem als Sollwertgeber (28) ausgebildeten Lautstärkesteller (13) verbunden ist.

In dem Ausführungsbeispiel gemäß Fig. 3 weist der Stellgrößengenerator (18) einen Subtrahierer (26) und einen diesem nachgeschalteten Integrierer (27) auf. An dem einen Eingang des Subtrahieres (26) liegt das Ähnlichkeitssignal $(\bar{x})$ und an dem anderen Eingang eine vom Sollwertgeber (28) vorgegebene Stellspannung $U_{Soll}$. Die Differenzspannung am Ausgang des Subtrahierers (26) wird im Integrierer (27) integriert und als Stellgröße (z) unmittelbar dem Steuereingang (14) des Regelverstärkers (12) zugeführt.

In dem Ausführungsbeispiel gemäß Fig. 4 weist der Stellgrößengenerator (18') eine Vielzahl von Schwellwertschaltern (40) und eine gleiche Anzahl von schaltbaren Dämpfungsgliedern (41) auf. Im gewählten Ausführungsbeispiel sind die Dämpfungsglieder in Reihe geschaltet. Die Reihenschaltung der Dämpfungsglieder (41) ist zwischen dem mit dem Sollwertgeber (28) verbundenen Eingang und dem Ausgang des Stellgrößengenerators (18') angeschlossen.

Jedes Dämpfungsglied ist mittels eines zugeordneten Schwellwertschalters (40) zu- und abschaltbar, was durch den Dämpfungsgliedern (41) parallel geschalteten Ein-/Ausschaltern (42) symbolisch dargestellt ist. Jeder Schwellwertschalter (40) weist zur Erzeugung einer Schalthysterese eine obere Schaltschwelle und eine untere Schaltschwelle auf. Bei Überschreiten der oberen Schaltschwelle wird der jeweils zugeordnete Schalter (42) geöffnet, damit das zugeordnete Dämpfungsglied (41) zugeschaltet und die Stellgröße (z) um einen Schritt reduziert. Bei Unterschreiten der unteren Schaltschwelle wird der zugeordnete Schalter (42) geschlossen, damit das zugeordnete Dämpfungsglied (41) überbrückt, also abgeschaltet, und die Stellgröße (z) um einen Schritt erhöht. Die Schaltschwellen der Schwellwertschalter (40) sind gegeneinander so abgestuft, daß sich ein dem subjektiven Lautstärkeempfinden des menschlichen Ohrs optimal angepaßtes Regelverhalten ergibt. Nimmt das Ähnlichkeitssignal $(\bar{x})$ seinen größten Wert $U_x$ an (was bedeutet, daß Mikrofonausgangssignal und Nutzsignal identisch sind, also kein Störgeräusch vorhanden ist), so sind alle Schalter (42) geöffnet. Die dem Regelverstärker (12) zugeführte Stellgröße (z) ist minimal und ausschließlich von der Einstellung des Lautstärkestellers (13) abhängig. Sobald ein Störgeräusch auftritt, die Hüllkurvensignale sich weniger ähnlich sind, nimmt der Wert des Ähnlichkeitssignals $(\bar{x})$ ab. Sobald die untere Schaltschwelle des ersten Schwellwertschalters (40) unterschritten wird, wird der zugeordnete Schalter (42) geschlossen und damit die Stellgröße (z) um einen Schritt erhöht. Bei Unterschreiten der nächsten unteren Schaltschwelle spricht der nächste Schwellwertschalter (40) an und die Stellspannung $U_{Soll}$ wird um einen weiteren, z. B. gleichen Betrag erhöht und so fort. Sind die Hüllkurvensignale extrem unähnlich, so weist das Ähnlichkeitssignal $(\overline{x})$ ungefähr den Wert Null auf und alle Schalter (42) sind geschlossen. Die dem Regelverstärker (12) zugeführte Stellgröße (z) ist maximal. Die Schwellwertschalter (40) können z. B. als Schmitt-Trigger ausgebildet sein.

Der vorstehend beschriebene Regelmechanismus nutzt die Dynamik der Signale aus. Da aber auch in der Praxis Rauschsignale ohne wesentliche Dynamik vorkommen und störend wirken, werden zur Erfassung solcher Rauschsignale die am Ausgang des Umschalters (24) anstehenden Ausgabewerte $+ U_x$ und $— U_x$ gewichtet. Hierzu werden von den an den Eingängen a und b der Vergleichsschaltung (17) anstehenden Hüllkurvensignale von Nutzsignal einerseits und Mikrofonausgangssignal andererseits jeweils der Mittelwert und der Dynamikbereich bestimmt. Aus diesen Mittelwerten und Dynamikbereichen wird ein Dynamik- oder Wichtungsfaktor gewonnen, der zur Wichtung dieser Ausgabewerte dient. Gemäß einer ersten Verfahrensvariante wird dabei der Dynamikfaktor als Quotient der beiden Hüllkurvenverhältnisse der Hüllkurvensignale berechnet. Unter Hüllkurvenverhältnisse wird hierbei der Quotient des Mittelwertes zu dem Dynamikbereich eines Hüllkurvensignals verstanden.

Nach einer zweiten Verfahrensvariante, das wesentlich bessere Ergebnisse liefert, wird der Dynamikfaktor als Differenz aus dem Mittelwert des aus dem Mikrofonausgangssignal abgeleiteten Hüllkurvensignals und dem mit dem Mittelwert des Nutzsignal-Hüllkurvensignals multiplizierten Verhältnis der Dynamikbereiche der aus dem Mikrofonausgangssignal und aus dem Nutzsignal abgeleiteten Hüllkurvensignale gebildet. Die Wichtung erfolgt dann derart, daß der größere Ausgabewert um den Dynamikfaktor verkleinert und der kleinere Ausgabewert um den Dynamikfator vergrößert wird.

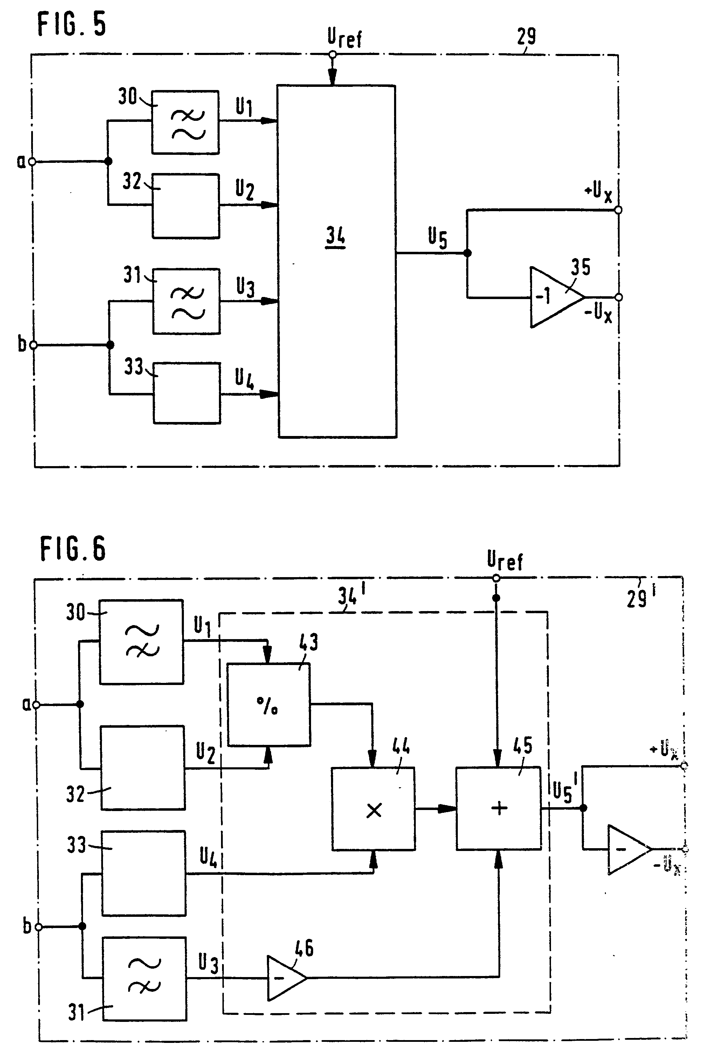

Zur Wichtung der Ausgabewerte $+ U_x$ und $— U_x$ weist die Vergleichsschaltung (17) eine Wichtungsvorrichtung (29 oder 29') auf, die im einzelnen in Fig. 5 bzw. 6 dargestellt ist. Bei beiden Wichtungsvorrichtungen (29 und 29') sind die an die Hüllkurvendetektoren (15, 16) angeschlossenen Eingänge a und b der Vergleichsschaltung (17) jeweils mit einem als Tiefpaß (30 bzw. 31) ausgebildeten Mittelwertbildner und einem Dynamikdetektor (32 bzw. 33) verbunden. Die Dynamikdetektoren (32, 33) sind Umformer zur Umwandlung des Spitze-Spitze-Wertes der Hüllkurvensignale in eine Gleichspannung. Ein solcher Umformer kann aus zwei Spitzenwertdetektoren und einem Subtrahierer bestehen, wobei jeweils ein Spitzenwertdetektor den oberen bzw. unteren Spitzenwert des Hüllkurvensignals erfaßt. Die Ausgänge der insgesamt zwei Tiefpässe (30, 31) und der beiden Dynamikdetektoren (32, 33) sind mit einem Rechenwerk (34 bzw. 34') verbunden. Am Ausgang des Rechenwerkes (34 bzw. 34') ist ein Gleichspannungswert $U_5$ bzw. $U_{5'}$ abnehmbar, der unmittelbar als gewichteter Spannungswert $+ U_x$ an dem Eingang des Umschalters (24) und über einen Negierer (35 bzw. 35') als gewichteter Spannungswert $— U_x$ am anderen Eingang des Umschalters (24) anliegt.

Das Rechenwerk (34) in Fig. 5 bildet aus den Ausgangsspannungen $U_1$ bis $U_4$ der Mittelwertbildner (30, 31) und der Dynamikdetektoren (32, 33) und einer Referenzgleichspannung $U_{ref}$, die Gleichspannung $U_5$ gemäß

$$U_5 = \frac{U_1 \times U_4}{U_2 \times U_3} U_{ref'}$$

Der Dynamikfaktor a gemäß

$$a = \frac{U_1 \times U_4}{U_2 \times U_3}$$

ist 1, wenn kein Störgeräusch vorhanden ist und sonst immer kleiner als 1. Durch die Wichtungsvorrichtung (29) wird somit erreicht, daß der größere Spannungswert $+ U_x$ um einen durch den Dynamikfaktor a bestimmten Betrag verkleinert und der kleinere Spannungswert $— U_x$ um den gleichen Betrag vergrößert ist, wenn das dem Mikrofonausgangssignal zugeordnete Hüllkurvenverhältnis $U_3/U_4$ größer ist als das dem Nutzsignal zugehörige Hüllkurvenverhältnis $U_1/U_2$. Unter Hüllkurvenverhältnis wird — wie vorstehend bereits erwähnt — das Verhältnis des Mittelwertes $U_1$ bzw. $U_3$ zu dem Spitze-Spitze-Wert $U_2$ bzw. $U_4$ der Hüllkurvensignale an den Eingängen a bzw. b der Vergleichsschaltung 17 bezeichnet.

Das Rechenwerk (34') in der Wichtungsvorrichtung (29') in Fig. 6 bildet aus den Eingangsspannungen $U_1$ bis $U_4$ der Tiefpässe (30, 31) und der Dynamikdetektoren (32, 33) und der Referenzgleichspannung $U_{ref}$, die dem Maximalwert des Mikrofonsignals entspricht, die Spannung $U'_5$ gemäß

$$U'_5 = U_{ref} — U_3 — U_1 \times \frac{U_4}{U_2}.$$

Hierzu weist das Rechenwerk (34') einen Dividierer (43), einen Multiplizierer (44) und einen Addierer (45) auf, die in der in Fig. 6 dargestellten Weise miteinander und mit den Ausgängen der Tiefpässe (30, 31) und der Dynamikdetektoren (32, 33) verbunden sind. Zwischen dem Eingang des Addierers (45) und dem Ausgang des Tiefpasses (31) ist noch ein Inverter (46) eingeschaltet. Die Spannung $U'_5$ ist wiederum als gewichteter Spannungswert $+ U_x$ bzw. $-U_x$ dem Umschalter (24) zugeführt. Der Dynamikfaktor b gemäß

$$b = U_3 - U_1 \frac{U_4}{U_2}$$

ist immer Null, wenn kein Störgeräusch vorhanden ist und geht mit zunehmendem Rauschanteil gegen $U_{ref}$. Da die Wichtung im vorliegenden Ausführungsbeispiel immer so erfolgt, daß der ungewichtete größere Spannungswert um den Dynamikfaktor b reduziert und der kleinere ungewichtete Spannungswert um den Dynamikfaktor b vergrößert wird, ergibt sich für das Ähnlichkeitssignal (x)

$$x = (2W-1) \times (U_{ref}-b),$$

wobei W die Wahrscheinlichkeit für gleiche Vorzeichen der Steigungen der Hüllkurvensignale (W = 1) bei identischen Signalen und W = 0,5 bei unkorrelierten Hüllkurvensignalen ist. Ist also entweder der Rauschanteil sehr groß ($b-U_{ref}$) oder keine Ähnlichkeit der Hüllkurvensignale vorhanden (W = 0,5), ergibt sich der kleinstmögliche Ähnlichkeitswert x = 0, der eine max. Stellgröße (z) erfordert. Umgekehrt ergibt sich bei fehlendem Rauschanteil (B—0) und max. Hüllkurven-Übereinstimmung (W = 1) der max. Ähnlichkeitswert $x = U_{ref}$, der eine minimale Stellgröße (z) erfordert.

Wie nicht weiter dargestellt, aber per Software oder Hardware ohne weiteres realisierbar, wird der Ähnlichkeitsvergleich der Hüllkurven von elektrischem Nutzsignal $U_{Nutz}$ und elektrischem Mikrofonausgangssignal nur außerhalb von Signalpausen im Nutzsignal durchgeführt. Hierzu werden im Nutzsignal die Signalpausen detektiert und während dieser Signalpausen der Ähnlichkeitsvergleich unterbunden. Dadurch wird verhindert, daß in Signalpausen das Ähnlichkeitssignal bei anwesendem Störgeräusch sehr klein wird und damit unzulässigerweise zu einer großen Stellgröße führt. Außerdem kann zur Unterbindung des Einflusses der kurzzeitigen Dynamik der Nutz- und Störgeräuschsignale eine Lautstärkeanpassung und damit eine Veränderung der Stellgröße (z) nur dann vorgenommen werden, wenn sich der Wert der Stellgröße (z) außerhalb eines vorgegebenen Toleranzfensters befindet. Bei dem Stellgrößengenerator (18) gemäß Fig. 3 ist dieses Toleranzfenster um den Sollwert $U_{Soll}$ gelegt. Die Erfindung ist nicht auf das vorstehend beschriebene Ausführungsbeispiel der analogen Schaltungsanordnung beschränkt. So kann das erfindungsgemäße Verfahren digital realisiert werden. In diesem Fall sind die Spannungswerte $+ U_x$ und $-U_x$ digitale Werte mit vorgegebener Größe bzw. Null, deren in einer ALU berechneter Mittelwert das digitale Ähnlichkeitssignal (x) bildet. Das Verfahren funktioniert in gleicher Weise und auch die Wirkungsweise der digitalen Vorrichtung ist wie vorstehend beschrieben, unter Berücksichtigung der durch die Digitaltechnik geforderten Besonderheiten.

Anstelle des Koinzidenzgliedes (23) in Fig. 2 kann auch ein Exklusiv-Oder-Gatter zusammen mit dem Umschalter (24) eine Koinzidenzschaltung bilden. In diesem Fall sind bei gleicher Stellung des Umschalters (24) die Ausgangssignale des Exklusiv-Oder-Gatters gegenüber denen des Koinzidenzgliedes (23) vertauscht.

**Patentansprüche**

1. Verfahren zum Anpassen der Lautstärke eines Lautsprechers, insbesondere in einem mobilen Rundfunkempfänger, wie Autoradio oder dergleichen, an einem am Lautsprecherort herrschenden Störgeräuschpegel unter Verwendung eines steuerbaren Regelverstärkers zum Verstärken eines Nutzsignals für den Lautsprecher und eines Mikrofons zum Erfassen eines aus Lautsprecherausgangssignal und Störgeräusch zusammengesetzten akustischen Signals, bei welchem mittels Vergleichs des elektrischen Mikrofonausgangssignals mit dem Nutzsignal eine Stellgröße für den Regelverstärker generiert wird, dadurch gekennzeichnet, daß die Hüllkurven von Nutzsignal und Mikrofonausgangssignal fortlaufend auf Ähnlichkeit geprüft werden, indem die Vorzeichen der Steigungen der Hüllkurven fortlaufend bestimmt werden, daß die Vorzeichen verglichen werden und bei Gleichheit ein vorgegebener erster Wert und bei Ungleichheit ein davon abweichender vorgegebener zweiter Wert ausgegeben wird, und daß als Mittelwert der Ausgabewerte ein dem Ähnlichkeitsgrad proportionales Ähnlichkeitssignal erzeugt wird, und daß die Stellgröße aus dem Ähnlichkeitssignal abgeleitet wird.

2. Verfahren nach Anspruch 1, dadurch gekennzeichnet, daß zur Ableitung der Stellgröße aus dem Ähnlichkeitssignal dieses mit einem vorzugsweise in Abhängigkeit von der mittels eines Lautstärkestellers vorgewählten Lautstärke vorgegebenen Sollwert verglichen, und daß durch Integration der Differenzwerte zwischen Ähnlichkeitssignal und Sollwert die Stellgröße bestimmt wird.

3. Verfahren nach Anspruch 1, dadurch gekennzeichnet, daß zur Ableitung der Stellgröße aus dem Ähnlichkeitssignal mindestens ein Teil des Variationsbereichs des Ähnlichkeitssignals durch Schwellwertstufen unterteilt wird, und daß bei Durchlaufen der Schwellwertstufen durch das Ähnlichkeitssignal eine mittels eines Lautstärkestellers vorgewählte Lautstärke je nach Durchlaufrichtung um je einen Schritt erhöht oder reduziert wird, wobei den Schwellwertstufen jeweils eine obere und eine untere Schaltschwelle zugeordnet werden, und daß die Stellgröße bei Unterschreiten der unteren Schaltschwelle erhöht und bei Überschreiten der oberen Schaltschwelle reduziert wird.

4. Verfahren nach Anspruch 1, dadurch gekennzeichnet, daß aus dem Nutzsignal und aus dem Mikrofonausgangssignal jeweils ein Hüllkurvensignal abgeleitet wird, daß der Mittelwert und der Dynamikbereich von jedem Hüllkurvensignal bestimmt werden und daraus ein Dynamikfaktor gewonnen wird; und daß die Ausgabewerte mit dem Dynamikfaktor gewichtet werden.

5. Verfahren nach Anspruch 4, dadurch gekennzeichnet, daß der Dynamikfaktor als Differenz aus dem Mittelwert des aus dem Mikrofonausgangssignal abgeleiteten Hüllkurvensignals und dem mit dem Mittelwert des Nutzsignal-Hüllkurvensignals multiplizierten Verhältnisses der Dynamikbereiche der aus dem Mikrofonausgangssignal und aus dem Nutzsignal abgeleiteten Hüllkurvensignale gebildet wird, wobei die Wichtung derart erfolgt, daß der größere Ausgabewert um den Dynamikfaktor verkleinert und der kleinere Ausgabewert um den Dynamikfaktor vergrößert wird.

6. Verfahren nach einem der Ansprüche 1-5, dadurch gekennzeichnet, daß Signalpausen im Nutzsignal detektiert werden, und daß während der Signalpausen ein Ähnlichkeitsvergleich der Hüllkurven unterbunden wird.

7. Schaltungsanordnung zum Durchführen des Verfahrens nach einem der Ansprüche 1-6 mit einem einem Lautsprecher (10) vorgeschalteten Regelverstärker (12) mit darauf einwirkendem manuellen Lautstärkesteller (13), mit einem Mikrofon (11) zum Aufnehmen eines aus Lautsprecherausgangssignal und Störgeräusch zusammengesetzten akustischen Signals und mit einer Regelvorrichtung (36), welche mittels Vergleichs des Mikrofonausgangssignals mit dem Nutzsignal eine störgeräuschproportionale Stellgröße für den Regelverstärker (12) erzeugt, dadurch gekennzeichnet, daß die Regelvorrichtung (36) zwei Hüllkurvendetektoren (15, 16) aufweist, von denen der eine mit seinem Eingang an dem Eingang des Regelverstärkers (12) und der andere mit seinem Eingang an dem Mikrofonausgang angeschlossen ist, daß mit den Ausgängen der Hüllkurvendetektoren (15, 16) die beiden Eingänge (a, b) einer Vergleichsschaltung (17) verbunden sind, die zwei jeweils das Vorzeichen der Hüllkurvensteigungen erfassende Detektoren (19, 21 bzw. 20, 22), eine mit den Detektoren (19, 21 bzw. 20, 22) verbundene Koinzidenzschaltung (23, 24), die bei Vorzeichen-Übereinstimmung einen vorgegebenen ersten Wert ($+ U_x$) und bei Nichtübereinstimmung der Vorzeichen einen vorgegebenen zweiten Wert ($-U_x$) ausgibt und einen der Koinzidenzschaltung (23, 24) nachgeschalteten Mittelwertbildner (25) aufweist, dessen das Ähnlichkeitssi-gnal ($\overline{x}$) führender Ausgang den Ausgang der Vergleichsschaltung (17) bildet, und daß der Vergleichsschaltung (17) ein Stellgrößengenerator (18, 18') nachgeschaltet ist, dessen Ausgang mit dem Steuereingang (14) des Regelverstärkers (12) verbunden ist.

8. Schaltungsanordnung nach Anspruch 7, dadurch gekennzeichnet, daß der Stellgrößengenerator (18) einen Subtrahierer (26) und einen diesem nachgeschalteten Integrierer (27) aufweist, und daß der eine Eingang des Subtrahierers (26) mit dem Ähnlichkeitssignal ($\overline{x}$) und der andere Eingang des Subtrahierers (26) mit einem vorzugsweise von der Einstellung des Lautstärkestellers (13) abhängigen Sollwert ($U_{Soll}$) belegt ist.

**Claims**

1. Method for matching the volume of a loudspeaker, particularly in a mobile radio receiver such as a car radio or the like, to an interfering noise level prevailing at the location of the loudspeaker, using a controllable control amplifier for amplifying a useful signal for the loudspeaker and a microphone for detecting an acoustical signal composed of the loudspeaker output signal and the intefering noise, in which a control variable for the control amplifier is generated by means of a comparison of the electric microphone output signal with the useful signal, characterized in that the envelope curves of the useful signal and the microphone output signal are continuously checked for similarity in that the signs of the slopes of the envelope curves are continuously determined, that the signs are compared and, in the case of equality, a predetermined first value and, in the case of inequality, a predetermined second value deviating from the first value is output, and that a similarity signal proportional to the degree of similarity is generated as mean value of the output values, and that the control variable is derived from the similarity signal.

2. Method according to claim 1, characterized in that, for deriving the control variable from the similarity signal, the latter is compared with a nominal value preferably predetermined in dependence on the volume preselected by means of a volume control, and that the control variable is determined by integration of the difference values between similarity signal and nominal signal.

3. Method according to claim 1, characterized in that, for deriving the control variable from the similarity signal, at least a part of the range of variation of the similarity signal is subdivided by threshold steps, and that when the similarity signal passes through the threshold steps, a volume preselected by means of a volume control is increased or reduced by one step each depending on the direction of passage, an upper and a lower switching threshold being allocated in each case to the threshold steps, and that the control variable is increased if the signal drops below the lower switching threshold and is reduced when it exceeds the upper switching threshold.

7

4. Method according to claim 1, characterized in that an envelope curve signal is in each case derived from the useful signal and from the microphone output signal, that the mean value and the dynamic range of each envelope curve signal are determined and from these a dynamic range factor is obtained, and that the output values are weighted with the dynamic range factor.

5. Method according to claim 4, characterized in that the dynamic range factor is formed as the difference of the mean value of the envelope curve signal derived from the microphone output signal and the ratio, multiplied by the mean value of the useful signal envelope curve signal, of the dynamic ranges of the envelope curve signals derived from the microphone output signal and from the useful signal, the weighting being effected in such a manner that the greater output value is reduced by the dynamic range factor and the smaller output value is increased by the dynamic range factor.

6. Method according to one of claims 1-5, characterized in that signal pauses in the useful signal are detected and that a similarity comparison of the envelope curves is suppressed during the signal pauses.

7. Circuit arrangement for carrying out the method according to one of claims 1-6, comprising a control amplifier (12), preceding a loudspeaker (10), with a manual volume control (13) acting on the control amplifier, with a microphone (11) for picking up an acoustic signal composed of a loudspeaker output signal and interfering noise and with a control device (36) which generates, by means of comparison of the microphone output signal with the useful signal, an interfering-noise-proportional control variable for the control amplifier (12), characterized in that the control device (36) exhibits two envelope curve detectors (15, 16), one of which is connected with its input to the input of the control amplifier (12) and the other one of which is connected with its input to the microphone output, that the outputs of the envelope curve detectors (15, 16) are connected to the two inputs (a, b) of a comparison circuit (17) which exhibits two detectors (19, 21 and 20, 22) which in each case detects the sign of the envelope curve slopes, a coincidence circuit (23, 24) which is connected to the detectors (19, 21 and 20, 22) which outputs a predetermined first value ($+ U_x$) if the signs match and outputs a predetermined second value ($-U_x$) if the signs do not match, and a mean value forming circuit (25) which follows the coincidence circuit (23, 24) the output of which, which carries the similarity signal ($\overline{x}$), forms the output of the comparison circuit (17), and that the comparison circuit (17) is followed by a control variable generator (18, 18') the output of which is connected to the control input (14) of the control amplifier (12).

8. Circuit arrangement according to claim 7, characterized in that the control variable generator (18) exhibits a subtracting stage (26) and an integrator (27) which follows the latter, and that the similarity signal ($\overline{x}$) is applied to one input of the subtracting stage (26) and that a nominal value ($U_{nominal}$), which is preferably dependent on the setting of the volume control (13), is applied to the other input of the subtracting stage (26).

## Revendications

1. Procédé pour adapter l'intensité sonore d'un haut-parleur en particulier d'un récepteur radiophonique mobile tel qu'un auto-radio ou analogue, suivant le niveau de bruit parasite régnant à l'endroit où se trouve le haut-parleur, en utilisant un amplificateur de réglage, commandé pour amplifier un signal utile destiné au haut-parleur et un microphone pour recevoir le signal acoustique composé du signal de sortie du haut-parleur et du bruit parasite, pour générer par comparaison du signal de sortie électrique du microphone et du signal utile, une grandeur de réglage de l'amplificateur de réglage, procédé caractérisé en ce qu'on contrôle en continu l'analogie des courbes-enveloppes du signal utile et du signal de sortie du microphone, en déterminant en continu le signe algébrique de la pente des courbes-enveloppes, on compare les signes algébriques et en cas d'égalité, on génère une première valeur prédéterminée et en cas d'inégalité on génère une seconde valeur prédéterminée différente de la première, et comme valeur moyenne on génère les grandeurs de sortie d'un signal de similitude, proportionnel au degré d'analogie et en ce qu'on forme la grandeur de réglage à partir du signal de similitude.

2. Procédé selon la revendication 1, caractérisé en ce que pour former la grandeur de réglage à partir du signal de similitude, on compare celle-ci à une valeur de consigne, prédéterminée, de préférence en fonction de l'intensité sonore préréglée à l'aide d'un sélecteur de volume sonore et en ce que par intégration des différences entre le signal de similitude et la grandeur de consigne, on détermine la grandeur de réglage.

3. Procédé selon la revendication 1, caractérisé en ce que pour obtenir la grandeur de réglage à partir du signal de similitude, on subdivise au moins une partie de la plage de variation du signal de similitude en des échelons à seuil et lorsque le signal de similitude passe des échelons à seuil, on augmente ou on réduit d'un pas à l'aide d'un organe de réglage d'intensité sonore, le son pré-sélectionné suivant le sens de passage et on associe aux échelons à valeur de seuil chaque fois un seuil de commutation supérieur et un seuil de commutation inférieur, en augmentant la grandeur de réglage lorsqu'on passe en dessous du seuil de commutation inférieur et en réduisant la grandeur de réglage lorsqu'on passe au-dessus du seuil de commutation supérieur.

4. Procédé selon la revendication 1, caractérisé en ce qu'à partir du signal utile et du signal de sortie du microphone on dérive respectivement un signal de courbe-enveloppe, on détermine la valeur moyenne et la plage de dynamique de chaque signal de courbe-enveloppe, on en déduit un coefficient de dynamique et on pondère les grandeurs de sortie par le coefficient de dynamique.

5. Procédé selon la revendication 4, caractérisé en ce que le coefficient de dynamique est formé comme différence de la valeur moyenne du signal de courbe-enveloppe dérivé du signal de sortie du microphone et des signaux de courbe-enveloppe déduits de la valeur moyenne du rapport de la plage dynamique du signal de sortie du microphone, multiplié par le signal utile/signal de courbe-enveloppe ainsi que du signal utile, la pondération étant telle que la plus grande valeur de sortie soit diminuée du coefficient de dynamique et que la plus petite grandeur de sortie soit augmentée du coefficient de dynamique.

6. Procédé selon l'une des revendications 1 à 5, caractérisé en ce qu'on détecte des pauses dans le signal utile et pendant les pauses du signal, on supprime la comparaison de similitude des courbes-enveloppes.

7. Circuit pour la mise en œuvre du procédé selon l'une des revendications 1 à 6, à l'aide d'un amplificateur de réglage (12) relié à un haut-parleur (10), amplificateur commandé par un dispositif de réglage manuel d'intensité sonore (13) avec un microphone (11) pour recevoir un signal acoustique composé du signal de sortie du haut-parleur et du bruit parasite ainsi que d'un dispositif de réglage (36) qui génère des grandeurs de réglage pour l'amplificateur de réglage (12), grandeurs proportionnelles au bruit parasite par comparaison du signal de sortie du microphone et du signal utile, dispositif caractérisé en ce que le dispositif de régulation (36) comporte deux détecteurs de courbe-enveloppe (15, 16), l'entrée de l'un étant reliée à l'entrée de l'amplificateur de réglage (12) et l'entrée de l'autre étant reliée à la sortie du microphone, les deux entrées (a, b) d'un comparateur (17) étant reliées aux sorties des détecteurs de courbe-enveloppe (15, 16), un circuit de comparaison comportant deux détecteurs (19, 21, 20, 22) qui détectent respectivement le signe algébrique des pentes des courbes-enveloppes un circuit de coïncidence (23, 24) relié aux détecteurs (19, 21 ; 20, 22), circuit qui en cas de coïncidence du signe algébrique fournit une première valeur prédéterminée ($+ U_x$) et en cas de non coïncidence du signe algébrique, émet une seconde valeur prédéterminée ($-U_x$) et un générateur de valeur moyenne (25) en sortie du circuit de coïncidence (23, 24), générateur dont la sortie qui fournit le signal de similitude ($\bar{x}$) constitue la sortie du circuit de comparaison (17) et en ce que le circuit de comparaison (17) est suivi par un générateur de grandeur de réglage (18, 18') dont la sortie est reliée à l'entrée de commande (14) de l'amplificateur de réglage (12).

8. Circuit selon la revendication 7, caractérisé en ce que le générateur de grandeur de réglage (18) comprend un soustracteur (26) et un intégrateur (27) en aval du soustracteur et en ce que l'une des entrées du soustracteur (26) reçoit le signal de similitude ($\bar{x}$) et l'autre entrée du soustracteur (26) reçoit une grandeur de consigne ($U_{Soll}$) dépendant de préférence du réglage du dispositif de réglage de l'intensité sonore (13).

FIG.1

$U_{Nutz}$

13

28

$U_{Soll}$

14 Z

18 / 18$^I$

10

12

11

$\overline{x}$

15

a

36

17

b

16

FIG.2

17

19

21

23

24

25

$U_{ref}$

29 / 29$^I$

$+U_x$

$-U_x$

$\frac{d}{dt}$

$\frac{d}{dt}$

20

22

(-)

$\overline{x}$

a

b

1

FIG. 3

18

26    27

x̄    26    27    z

U_Soll

FIG. 4

40    U_Soll

x̄    40    42    41    18'

z

## FIG. 5

## FIG. 6

3